# EUROPEAN PATENT APPLICATION

(11) **EP 4 503 105 A1**
(43) Date of publication of application: **05.02.2025**
(21) Application number: 23780600.5
(22) Date of filing: 28.03.2023
(51) Int. Cl.: H01L 21/52, B22F 1/00, B22F 7/08

(54) **SILVER PASTE AND COMPOSITE**

(30) Priority: 31.03.2022 JP 2022061188
(71) Applicant: Panasonic Intellectual Property Management Co., Ltd., Kadoma-shi, Osaka 571-0057 (JP)
(72) Inventor: KAWAMURA, Motoi, Kadoma-shi, Osaka 571-0057 (JP); HANABUSA, Kakeru, Kadoma-shi, Osaka 571-0057 (JP); KURACHI, Tsuyoshi, Kadoma-shi, Osaka 571-0057 (JP); MIYAZAKI, Kaori, Kadoma-shi, Osaka 571-0057 (JP); MARUO, Kohei, Kadoma-shi, Osaka 571-0057 (JP)
(74) Representative: Grünecker Patent- und Rechtsanwälte PartG mbB
(86) International application number: PCT/JP2023/012657
(87) International publication number: WO 2023/190591

(57) **Abstract**

The problem to be overcome by the present disclosure is to provide a silver paste with excellent storage stability. A silver paste contains silver particles (A), a silver compound (B), an amine (C), and a solvent (D). The proportion of the silver particles (A) is equal to or greater than 80% by mass and equal to or less than 92% by mass. The proportion of the amine (C) is less than 6% by mass.

## Description

### Technical Field

The present disclosure generally relates to a silver paste and a composite, and more particularly relates to a silver paste containing silver particles, a silver compound, and an amine and a composite formed out of the silver paste.

### Background Art

To mount a semiconductor chip on a board, a technique called "die bonding" is employed generally. According to the die bonding technique, a metallic powder paste interposed between a semiconductor chip and a board is sintered to form a bonding layer, with which the semiconductor chip is fixed onto the board.

Various types of silver pastes have been proposed as the silver paste for use in the die bonding process. Patent Document 1 discloses a sintered silver paste material having a structure in which generally spherical silver particles and an organic silver complex are kneaded into a slurry. Patent Document 2 discloses a silver paste containing a silver powder, an aliphatic acid silver, and an aliphatic amine. The silver powder includes: first silver particles with a particle size equal to or greater than 100 nm and less than 500 nm at a proportion equal to or greater than 55% by volume and equal to or less than 95% by volume; second silver particles with a particle size equal to or greater than 50 nm and less than 100 nm at a proportion equal to or greater than 5% by volume and equal to or less than 40% by volume; and third silver particles with a particle size less than 50 nm at a proportion equal to or less than 5% by volume.

According to one method, the amount of the silver compound added to such a silver paste for use in the die bonding process is increased to increase the bonding strength between the semiconductor chip and the sintered body. Increasing the amount of the silver compound added to the silver paste would cause a decrease in the storage stability of the silver paste so significantly as to produce nano-silver (i.e., nanoparticles of silver) in the silver paste with the passage of time. In that case, the nano-silver and the silver particles would no longer be dispersed uniformly. Consequently, this would cause a dispersion in performance between mounted products fabricated by bonding the chip with the silver paste.

### Citation List

### Patent Literature

Patent Document 1: JP 2011-249257 A
Patent Document 2: JP 2020-164974 A

### Summary of Invention

A primary object of the present disclosure is to provide a silver paste with excellent storage stability and a composite formed out of such a silver paste.

A silver paste according to an aspect of the present disclosure contains silver particles (A), a silver compound (B), an amine (C), and a solvent (D). The proportion of the silver particles (A) is equal to or greater than 80% by mass and equal to or less than 92% by mass. The proportion of the amine (C) is less than 6% by mass.

A composite according to another aspect of the present disclosure includes a base member, a member to be bonded, and a bonding layer interposed between the base member and the member to be bonded. The bonding layer includes a sintered body of the silver paste described above.

### Description of Embodiments

### 1. Overview

A silver paste (hereinafter referred to as a "silver paste (X)") according to an exemplary embodiment contains silver particles (A), a silver compound (B), an amine (C), and a solvent (D).

The present inventors carried out extensive research to overcome the problem described above. As a result, the present inventors discovered that there is a correlation between the contents and content ratio of respective components of the silver paste (X) and the performance of the silver paste (X) and a composite formed out of the silver paste (X), thereby conceiving the concept of the present disclosure.

The silver paste (X) according to an aspect of this embodiment has the following features (i) and (ii):
(i) the proportion of the silver particles (A) is equal to or greater than 80% by mass and equal to or less than 92% by mass; and
(ii) the proportion of the amine (C) is less than 6% by mass.

The silver paste (X) according to an aspect of this embodiment has excellent storage stability. The reason why the above-described problem may be overcome by the silver paste (X) with these features (i) and (ii) is not perfectly clear at this time but presumably as follows, for example. Setting the proportion of the silver particles (A) at a value equal to or less than 92% by mass as in the feature (i) allows the silver paste (X) to be prepared in a paste form. In addition, setting the proportion of the amine (C) at a value less than 6% by mass as in the feature (ii) allows the viscosity of the silver paste (X) to be maintained within an adequate range, which contributes to improving the storage stability.

Besides, the silver paste (X) according to one aspect of this embodiment may also reduce a dispersion in performance between mounted products fabricated by using the silver paste (X). Furthermore, using the silver paste (X) according to this aspect of this embodiment allows the mounted product to achieve a high bonding strength even after the mounted product has been subjected to a reliability test.

The silver paste (X) according to one aspect of this embodiment preferably further has the following features (iii) to (v):
(iii) the proportion of the silver compound (B) is equal to or greater than 0.5% by mass and equal to or less than 1.8% by mass,
(iv) a molar concentration of the silver compound (B) to the solvent (D) is equal to or higher than 0.1 mol/L and equal to or lower than 10 mol/L, and
(v) a molar ratio of an amino group included in the amine (C) to the silver compound (B) (hereinafter referred to as an "amino group/silver compound molar ratio") is greater than 2.5.

As can be seen, setting the proportion of the silver compound (B) at a value equal to or less than 1.8% by mass as in the feature (iii) and setting the amino group/silver compound molar ratio at a value greater than 2.5 as in the feature (v) reduces the frequency of occurrence of black precipitation (i.e., precipitation of reactive silver particles). The occurrence of the black precipitation would be one of the causes of dispersion in performance between mounted products. Thus, reducing the frequency of occurrence of the black precipitation would contribute to reducing the dispersion in performance between the mounted products. Also, a sufficient bonding strength would be achieved by setting the proportion of the silver particles (A) at a value equal to or greater than 80% by mass as in the feature (i) and setting the proportion of the silver compound (B) at a value equal to or greater than 0.5% by mass as in the feature (iii). In addition, the present inventors also discovered that when the proportion of the silver compound (B) was equal to or greater than 0.5% by mass and equal to or less than 1.8% by mass as in the feature (iii), the proportion of the amine (C) was less than 6% by mass as in the feature (ii), and the amino group/silver compound molar ratio was greater than 2.5 as in the feature (v), a sintered body formed by sintering the silver paste had a porous structure. Such a structure would also contribute to achieving a high bonding strength even after the silver paste (X) has been subjected to a reliability test.

As can be seen from the foregoing description, the present disclosure enables providing a silver paste with excellent storage stability and a composite formed out of such a silver paste.

### 2. Details

### <Silver paste>

A silver paste (X) according to this embodiment contains silver particles (A), a silver compound (B), an amine (C), and a solvent (D). Optionally, the silver paste (X) may further contain other components (E) unless the advantages of this embodiment are impaired.

Next, the respective components will be described one by one.

### [Silver particles (A)]

The silver particles (A) are metallic particles, of which the main component is silver. On the surface of the silver particles (A), silver is exposed. As used herein, the "main component" refers to a component with the largest content of the silver particles (A), and specifically refers to a component, of which the content is normally equal to or greater than 50% by mass and preferably equal to or greater than 70% by mass. The silver particles (A) may be synthesized by a method such as a plasma process.

The silver particles (A) preferably have a mean particle size equal to or greater than 50 nm and equal to or less than 500 nm. Setting the mean particle size of the silver particles (A) at a value less than 50 nm would cause an increase in their surface area and thereby cause an increase in the degree of activity of the silver particles (A) so significantly as to advance sintering even at room temperature and thereby make it difficult to maintain the stability of the silver paste (X) in some cases. On the other hand, setting the mean particle size of the silver particles (A) at a value greater than 500 nm would cause a decrease in the surface area of the silver particles (A) and thereby slow down the sintering process significantly in some cases. As used herein, the "mean particle size" of the silver particles (A) refers to a particle size calculated based on a scanning electron microscope (SEM) photograph. The silver particles (A) more preferably have a mean particle size equal to or greater than 100 nm and equal to or less than 400 nm.

Optionally, the surface of the silver particles (A) may be coated with at least one of an organic acid or an alkylamine. Examples of the organic acid include ascorbic acid, formic acid, tartaric acid, citric acid, malic acid, lactic acid, succinic acid, butyric acid, fumaric acid, and propionic acid. The number of carbon atoms of the alkyl group included in the alkylamine to coat the surface of the silver particles (A) is preferably equal to or greater than 3 and equal to or less than 20. Making the number of carbon atoms greater than 20 would inhibit sintering of the silver particles (A) due to steric hindrance of the alkylamine, thus possibly causing a decrease in electrical conductivity and bonding strength.

It is important that the proportion of the silver particles (A) is equal to or greater than 80% by mass and equal to or less than 92% by mass with respect to the silver paste (X). Setting the proportion of the silver particles (A) at a value less than 80% by mass would cause a decrease in the number of points of contact between the silver particles themselves or between the silver particles and the silver nanoparticles during the sintering process, thus causing such a significant delay in the sintering between the silver particles and the silver nanoparticles as to make the bonding strength between the sintered body and the chip insufficient. On the other hand, setting the proportion of the silver particles (A) at a value greater than 92% by mass would prevent other constituent materials from making the surface of the silver particles (A) wet, thus making it difficult to make the paste.

### [Silver compound (B)]

The silver compound (B) herein refers to a compound containing silver and is normally a compound having silver ions. The silver particles (A) are not included in the silver compound (B).

Examples of the silver compound (B) include silver salts and silver complexes.

Examples of the silver salts include: silver salts of monocarboxylic acids such as silver acetate, silver propionate, silver myristate, silver butyrate, silver neodecanoate, silver oleate, silver linoleate, silver caprylate, silver caprate, silver 2-methylpropanoate, silver 2-methylbutanoate, silver 2-ethylbutanoate, and silver 2-ethylhexanoate; and silver salts of carboxylic acids including silver salts of dicarboxylic acids such as silver oxalate.

Examples of the silver complex include a silver ethylenediamine complex.

The silver compound (B) preferably contains a silver salt, more preferably contains a silver salt of a carboxylic acid, even more preferably contains at least one of a silver salt of a monocarboxylic acid or a silver salt of a dicarboxylic acid. The silver compound (B) particularly preferably contains a silver salt of a monocarboxylic acid and most preferably contains silver acetate. Adding any of these salts to the silver compound (B) enables further improving the storage stability.

The proportion of the silver compound (B) is preferably equal to or greater than 0.5% by mass and equal to or less than 1.8% by mass with respect to the silver paste (X). Setting the proportion of the silver compound (B) at a value less than 0.5% by mass causes a significant decrease in the amount of nano-silver produced during the sintering process, thus making it impossible to produce the nano-silver to an amount required to bond the silver particles (A) together and eventually making the bonding strength between the sintered body and the chip insufficient in some cases. On the other hand, setting the proportion of the silver compound (B) at a value greater than 1.8% by mass would cause silver to be deposited in the silver paste (X) and produce an excessive amount of nano-silver for the silver particles (A), thus sometimes making it difficult to maintain the viscosity of the silver paste (X) stably within a range suitable for printing. The proportion of the silver compound (B) is preferably equal to or greater than 0.5% by mass and equal to or less than 1.5% by mass and more preferably equal to or greater than 0.8% by mass and equal to or less than 1.3% by mass.

Furthermore, the molar concentration of the silver compound (B) to the solvent (D) is preferably equal to or higher than 0.1 mol/L and equal to or lower than 10 mol/L. Setting the molar concentration of the silver compound (B) to the solvent (D) at a value less than 0.1 mol/L would cause the silver compound (B) to form complexes insufficiently, thus sometimes causing a significant delay in bonding between the silver particles (A) and the silver nanoparticles and eventually causing a decrease in the bonding strength. In addition, a silver complex produced from the silver compound (B) has such high activity that making the molar concentration of the silver compound (B) to the solvent (D) higher than 10 mol/L would cause a reaction between the silver complexes produced from the silver compound (B) and thereby cause silver to be deposited. This deposition of silver would cause a decrease in the viscosity of the silver paste (X) and thereby cause a decline in the printability of the paste.

### [Amine (C)]

The amine (C) herein refers to a compound having an amino group (i.e., -NR₂, R=H, or a monovalent hydrocarbon group). The amine (C) may have a single amino group or two or more amino groups, whichever is appropriate.

Examples of the amine (C) include
monoamines including:
primary amines such as 2-ethylhexylamine, hexylamine, heptylamine, octylamine, nonylamine, aminodecane, dodecylamine, tetradecylamine, cyclohexylamine, and aniline;
secondary amines such as dipropylamine, dibutylamine, and dihexylamine; and
tertiary amines such as tripropylamine and tributylamine,
diamines such as dimethylaminopropylamine, diethylaminopropylamine, and dibutylaminopropylamine,
amino alcohols such as 3-amino-1-propanol, 1-amino-2-propanol, N-methylethanolamine, 3-(dimethylamino)-1-propanol, monoethanolamine, diethanolamine, triethanolamine, N-methyldiethanolamine, and N- ethyldiethanolamine, and
ammonia.

The amine (C) is preferably at least one of a monoamine or an amino alcohol, more preferably an amino alcohol, and even more preferably 1-amino-2-propanol. Adding any of these compounds to the amine (C) enables further improving the storage stability.

It is important that the proportion of the amine (C) is less than 6% by mass with respect to the silver paste (X). Setting the proportion of the amine (C) at a value equal to or greater than 6% by mass would produce an excessive amount of nano-silver in the silver paste, thus making it difficult to maintain the viscosity of the silver paste stably within the range suitable for printing. The proportion of the amine (C) is preferably equal to or less than 5% by mass, more preferably equal to or less than 4% by mass, and even more preferably equal to or less than 3% by mass. The lower limit of the proportion of the amine (C) may be, without limitation, equal to or greater than 0.1% by mass, for example, and is preferably equal to or greater than 1% by mass and more preferably equal to or greater than 2% by mass.

The molar ratio of the amino group included in the amine (C) to the silver compound (B) (i.e., the amino group/silver compound molar ratio) is preferably greater than 2.5. As used herein, the "amino group/silver compound molar ratio" refers to the ratio of the number of moles of the amino group included in the amine (C) to the number of moles of the silver compound (B). Setting the amino group/silver compound molar ratio at a value equal to or less than 2.5 would sometimes cause black precipitation (i.e., precipitation of reactive silver particles) while a solution of the silver compound (B) is in chilled storage. That is why the black precipitation would also occur while the silver paste is being stored. Consequently, this would cause dispersion in performance between mounted products in actual use. The molar ratio is preferably equal to or greater than 3, more preferably equal to or greater than 4, and even more preferably equal to or greater than 5. The upper limit of the molar ratio may be, without limitation, equal to or less than 30, for example, and is preferably equal to or less than 20 and even more preferably equal to or less than 15.

### [Solvent (D)]

Any solvent may be used without limitation as the solvent (D) as long as the solvent (D) may be used to prepare the silver paste (X) in a paste form when mixed with constituent materials such as the silver particles (A). The solvent (D) preferably has a boiling point equal to or higher than 180°C. In that case, setting the boiling point of the solvent (D) at a temperature equal to or higher than 180°C reduces components that vaporize at an ordinary temperature, thus enabling reducing a variation in the solid content of the paste. Consequently, this allows the silver paste (X) to maintain a stabilized viscosity at the time of printing.

Examples of the solvent (D) include alcohol solvents, glycol solvents, glycol ether solvents, acetate solvents, ketone solvents, hydrocarbon solvents, and mixed solvents thereof.

Examples of the alcoholic solvent include isopropyl alcohol, butanol, heptanol, octanol, decanol, lauryl alcohol, tetradecyl alcohol, cetyl alcohol, terpineol, dihydroterpineol, and isobomylcyclohexanol.

Examples of the glycol solvent include 2-ethyl-1,3-hexanediol, ethylene glycol, propylene glycol, diethylene glycol, dipropylene glycol, and 2,3-butanediol.

Examples of the glycol ether solvent include ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, triethylene glycol monobutyl ether, propylene glycol monomethyl ether, and dipropylene glycol monomethyl ether.

Examples of the acetate solvent include butyl carbitol acetate.

Examples of the ketone solvent include methyl ethyl ketone, methyl isobutyl ketone, and isophorone.

Examples of the hydrocarbon solvent include decane, dodecane, and tetradecane.

The proportion of the solvent (D) is preferably equal to or less than 16% by mass with respect to the silver paste (X). This allows the viscosity of the silver paste (X) to be maintained at a viscosity more suitable for printing. The proportion of the solvent (D) is more preferably equal to or less than 12% by mass, even more preferably equal to or less than 9% by mass, and particularly preferably equal to or less than 7% by mass. The lower limit of the proportion of the solvent (D) may be, without limitation, equal to or greater than 0.1% by mass, for example, and is preferably equal to or greater than 1% by mass.

### [Other components (E)]

Examples of other components (E) include dispersants, epoxy resins, silicone resins, acrylic resins, and mixtures thereof. If the silver paste (X) contains the other components (E), the proportion of the other components (E) is preferably equal to or less than 3% by mass with respect to the silver paste (X).

### <Method for preparing silver paste>

The silver paste (X) may be prepared by, for example, mixing together the amine (C), the solvent (D), and the other components (E) as needed, and kneading a mixed solution, prepared by dissolving the silver compound (B) in the mixture thus obtained, with the silver particles (A). Any general kneading method may be used without limitation for kneading the silver particles (A) with the mixed solution. For example, after having been stirred up with a planetary stirrer or a planetary centrifugal mixer, for example, the silver particles (A) and the mixed solution may be kneaded with a three-roll mill, for example.

### <Composite>

A composite according to this embodiment (hereinafter referred to as a "composite (Y)") includes a base member, a member to be bonded, and a bonding layer. The bonding layer is interposed between the base member and the member to be bonded. The bonding layer includes a sintered body of the silver paste (X). The composite (Y) is formed out of the above-described silver paste (X), and therefore, may achieve a high bonding strength even after having been subjected to a reliability test.

The base member may be, for example, a wiring board. Specific examples of the base member include a motherboard, a package board, and an interposer board. The member to be bonded may be, for example, a semiconductor chip. More specifically, the member to be bonded may be a bare chip (die).

### <Method for fabricating composite>

The composite (Y) may be fabricated by, for example, printing the silver paste (X) onto the base member and prebaking the silver paste (X) to vaporize the solvent, mounting the member to be bonded (such as a semiconductor chip; i.e., making chip mounting) onto the silver paste (X) thus printed, and then sintering the assembly thus formed.

Any chip mounting method may be employed without limitation; the chip mounting may be carried out with or without pressure applied and/or with ultrasonic vibrations applied.

Any general sintering process technique may also be adopted without limitation; the process may be a continuous process or a batch process, whichever is appropriate. Examples of the heating temperature profile of the sintering process include: (a) raising the temperature from room temperature to 250°C at a temperature increase rate of about 3.5°C/s and then maintaining the temperature at 250°C for an hour and (b) raising the temperature from room temperature to about 350°C at a temperature increase rate of about 1.5°C/s, maintaining the temperature at about 350°C for 30 seconds, and then lowering the temperature at a cooling rate equal to or higher than 2°C/s.

### (Recapitulation)

As can be seen from the foregoing description, the exemplary embodiment and its variations described above are specific implementations of the following aspects of the present disclosure.

A silver paste (X) according to a first aspect contains silver particles (A), a silver compound (B), an amine (C), and a solvent (D). The proportion of the silver particles (A) is equal to or greater than 80% by mass and equal to or less than 92% by mass. The proportion of the amine (C) is less than 6% by mass.

The first aspect allows the silver paste (X) to have excellent storage stability.

In a silver paste (X) according to a second aspect, which may be implemented in conjunction with the first aspect, the proportion of the silver compound (B) is equal to or greater than 0.5% by mass and equal to or less than 1.8% by mass. A molar concentration of the silver compound (B) to the solvent (D) is equal to or higher than 0.1 mol/L and equal to or lower than 10 mol/L. A molar ratio of an amino group included in the amine (C) to the silver compound (B) is greater than 2.5.

The second aspect allows the silver paste to achieve a high bonding strength even after the silver paste has been subjected to a reliability test.

In a silver paste (X) according to a third aspect, which may be implemented in conjunction with the first or second aspect, the silver compound (B) includes a silver salt of a carboxylic acid.

The third aspect may further improve the storage stability of the silver paste (X).

In a silver paste (X) according to a fourth aspect, which may be implemented in conjunction with any one of the first to third aspects, the amine (C) includes at least one of a monoamine or an amino alcohol.

The fourth aspect may further improve the storage stability of the silver paste (X).

In a silver paste (X) according to a fifth aspect, which may be implemented in conjunction with any one of the first to fourth aspects, the solvent (D) has a boiling point equal to or higher than 180°C.

The fifth aspect allows the silver paste (X) to maintain a stabilized viscosity at the time of printing.

A composite (Y) according to a sixth aspect of the present disclosure includes a base member, a member to be bonded, and a bonding layer interposed between the base member and the member to be bonded. The bonding layer includes a sintered body of the silver paste (X) according to any one of the first to fifth aspects.

The sixth aspect enables providing a composite (Y), exhibiting an excellent bonding strength even after the composite (Y) has been subjected to a reliability test, by fabricating the composite (Y) using the above-described silver paste (X).

### Examples

Next, the present disclosure will be described in further detail by way of illustrative examples. Note that the examples to be described below are only examples of the present disclosure and should not be construed as limiting.

### 1. Preparation of silver paste

A silver paste (X) was prepared using silver particles (A), a silver compound (B), an amine (C), and a solvent (D), of which the respective amounts were as shown in the following Table 1.

The silver particles (A) were produced by the following wet process.

A silver-amine complex solution was prepared by mixing 3-methoxypropylamine (manufactured by FUJIFILM Wako Pure Chemical Corporation, 27 g) and silver oxalate (manufactured by Toyo Chemical Industrial., Inc., 9 g). To the solution thus prepared, 2 mol equivalent of hydrazine acetate (manufactured by FUJIFILM Wako Pure Chemical Corporation) was added to the silver-amine complex. Then, the mixture was heated to 35°C to be reacted, thereby obtaining a suspension in which silver particles were deposited. Next, the suspension was washed, subjected to a solid recovery operation such as centrifugation, and dried to obtain silver particles.

The silver particles thus obtained were observed through an SEM (JSM-7800F manufactured by JEOL Ltd.) at a zoom power of 30,000 to capture an SEM image. In the SEM images of 500 aggregates, the area of each silver particle was measured using image processing software (Image-J), and the circular diameter of the silver particle was calculated based on the area thus measured. The mean particle diameter was calculated to be 200 nm.

Silver acetate (manufactured by FUJIFILM Wako Pure Chemical Corporation) was used as the silver compound (B). As the amine (C), 1-amino-2-propanol (manufactured by FUJIFILM Wako Pure Chemical Corporation) was used. As the solvent (D), 2-ethyl-1,3-hexanediol (manufactured by FUJIFILM Wako Pure Chemical Corporation) was used.

First, the amine (C) and the solvent (D) were mixed, and the silver compound (B) was dissolved in the mixture thus prepared to obtain a silver compound solution (hereinafter also referred to as a "silver compound solution (α)"). A silver paste (X) was prepared by kneading this silver compound solution (α) and the silver particles (A) with each other.

### 2. Fabrication of composite

A silver-plated direct bonded copper (DBC) board (manufactured by Hirai Seimitsu Kogyo Co., Ltd.) was provided as the base member. The silver paste (X) prepared as described above was printed on the surface of the base member by screen printing method to have dimensions of 2.7 mm × 2.7 mm in plan view and a thickness of 0.9 mm. The base member on which this silver paste (X) had been printed was placed on a hot plate and heated at 40°C for 15 minutes to be prebaked. A 2.5 mm silver-plated Cu chip (manufactured by Hirai Seimitsu Kogyo Co., Ltd.) was provided as the member to be bonded. Then, the member to be bonded was stacked on the silver paste (X) that had been prebaked. In this manner, a laminate consisting of the base member, the silver paste (X), and the member to be bonded was fabricated. This laminate was maintained at 250°C for 60 minutes to sinter the silver paste (X) and thereby form a bonding layer. A composite (Y) including the base member, the bonding layer, and the member to be bonded was fabricated in this manner.

### 3. Evaluation

The silver paste (X) thus prepared was graded by (1) paste formation evaluation, (2) storage stability evaluation of the silver paste, (3) storage stability evaluation of the silver compound solution, and (4) thermal shock test (shear strength).

### (1) Paste formation evaluation

The paste formation evaluation was carried out in the following manner. If the silver paste (X) could be prepared into the paste form, then the sample was graded "A." On the other hand, if the silver paste (X) could not be prepared into the paste form but some particulates were visually recognized, then the sample was graded "B."

### (2) Storage stability of silver paste

The silver paste (X) prepared as described above was left at room temperature for one week. The silver paste had its viscosity measured before and after having been left, thereby calculating the rate of change in viscosity before and after the silver paste (X) had been left. The viscosity was measured using "RC-215U/RE-215U (rotor: SPP)" manufactured by Toki Sangyo Co., Ltd.

The room temperature storage stability of the silver paste was evaluated in the following manner. Specifically, if the viscosity change rate before and after the silver paste (X) had been left fell within ±50%, then the sample was graded "A." On the other hand, if the viscosity change rate before and after the silver paste (X) had been left fell outside of the range of ±50%, then the sample was graded "B." In Experimental Example 15, the viscosity change rate exceeded ±50% after the silver paste (X) had been left for 3 days. Thus, the sample was graded "C" in terms of room temperature storage stability.

### (3) Storage stability of silver compound solution

The silver compound solution (α) obtained while the silver paste was being prepared was left to be kept chilled at 4°C for one week. The silver compound solution that had been left in this manner for one week was observed with the naked eyes to see if there was any black precipitation. The chilled storage stability evaluation of the silver compound solution was carried out in the following manner. Specifically, if no black precipitation was visually recognized, the sample was graded "A." On the other hand, if any black precipitation was visually recognized, the sample was graded "B."

### (4) Thermal shock test (shear strength) evaluation

The composite (Y) fabricated as described above was exposed to an atmosphere at -40°C for 5 minutes, and then exposed to an atmosphere of 175°C for 5 minutes in one cycle. This process was repeated in 500 cycles. As for the composite (Y) that had been subjected to this test, the shear strength (MPa) between the member to be bonded (silver-plated Cu chip) and the base member (silver-plated DBC board) was measured using a 4000 universal bond tester (manufactured by Nordson Corporation).

**[Table 1]**

| | Experimental examples | | | | | | | | | | | | | | | | | |
|---|---|---|---|---|---|---|---|---|---|---|---|---|---|---|---|---|---|---|
| | 1 | 2 | 3 | 4 | 5 | 6 | 7 | 8 | 9 | 10 | 11 | 12 | 13 | 14 | 15 | 16 | 17 | 18 |
| Silver particles (A) (% by mass) | 85 | 85 | 80 | 92 | 85 | 85 | 85 | 85 | 85 | 85 | 85 | 85 | 85 | 85 | 85 | 85 | 85 | 92 |
| Silver compound (B) (% by mass) | 1.3 | 1.3 | 1.3 | 0.5 | 0.8 | 1.8 | 0.8 | 0.5 | 0.5 | 0.5 | 1.8 | 1.3 | 1.3 | 2.4 | 1.8 | 2.4 | 1.3 | 1.8 |
| Amine (C) (% by mass) | 3 | 4 | 3 | 1 | 3 | 3 | 2 | 2 | 3 | 4 | 2 | 1.45 | 6 | 5.5 | 6 | 2 | 9 | 5.2 |
| Solvent (D) (% by mass) | 10.7 | 9.7 | 15.7 | 6.5 | 11.2 | 10.2 | 12.2 | 12.5 | 11.5 | 10.5 | 11.2 | 12.3 | 7.7 | 7.1 | 7.2 | 10.6 | 4.7 | 1.0 |
| Amino group/silver compound molar ratio | 5.1 | 6.8 | 5.1 | 4.4 | 8.3 | 3.7 | 5.6 | 8.9 | 13.3 | 17.8 | 2.5 | 2.5 | 10.3 | 5.1 | 7.4 | 1.9 | 15.4 | 5.1 |
| Molar concentration (mol/L) of silver compound (B) to solvent (D) | 0.7 | 0.7 | 0.5 | 0.4 | 0.4 | 1.0 | 0.4 | 0.2 | 0.2 | 0.3 | 0.9 | 0.6 | 0.9 | 1.9 | 1.4 | 1.3 | 1.5 | 10.1 |
| (1) Paste formation evaluation | A | A | A | A | A | A | A | A | A | A | A | A | A | A | A | A | B | A |
| (2) Storage stability of silver paste | A | A | A | A | A | A | A | A | A | A | A | A | B | A | C | A | - | A |
| (3) Storage stability of silver compound solution | A | A | A | A | A | A | A | A | A | A | B | B | A | B | A | B | - | B |
| (4) Thermal shock test (shear strength) evaluation (MPa) | 60 | 45 | 40 | 70 | 80 | 50 | 50 | 50 | 55 | 60 | 30 | 30 | 45 | 33 | 45 | 35 | - | 38 |

As can be seen from the results shown in Table 1, each of the silver pastes according to Experimental Examples 1-10 exhibited excellent storage stability and also had a high bonding strength even after having been subjected to a reliability test. Each of the silver pastes according to Experimental Examples 11, 12, 14, 16, and 18 was graded "B" in terms of the storage stability of silver compound and their bonding strength after the silver paste had been subjected to the reliability test was short of 40 MPa. The silver paste according to Experimental Example 13 was graded "B" in terms of storage stability of silver paste. The silver paste according to Experimental Example 15 was graded "C" in terms of storage stability of silver paste. Note that the silver paste according to Experimental Example 17 could not be prepared into the paste form, and therefore, was not graded in terms of any of the evaluations (2) to (4).

## Claims

1. A silver paste containing silver particles (A), a silver compound (B), an amine (C), and a solvent (D),
proportion of the silver particles (A) being equal to or greater than 80% by mass and equal to or less than 92% by mass, and
proportion of the amine (C) being less than 6% by mass.

2. The silver paste of claim 1, wherein
proportion of the silver compound (B) is equal to or greater than 0.5% by mass and equal to or less than 1.8% by mass,
a molar concentration of the silver compound (B) to the solvent (D) is equal to or higher than 0.1 mol/L and equal to or lower than 10 mol/L, and
a molar ratio of an amino group included in the amine (C) to the silver compound (B) is greater than 2.5.

3. The silver paste of claim 1, wherein
the silver compound (B) includes a silver salt of a carboxylic acid.

4. The silver paste of claim 1, wherein
the amine (C) includes at least one of a monoamine or an amino alcohol.

5. The silver paste of claim 1, wherein
the solvent (D) has a boiling point equal to or higher than 180°C.

6. A composite comprising a base member, a member to be bonded, and a bonding layer interposed between the base member and the member to be bonded,
the bonding layer including a sintered body of the silver paste of any one of claims 1 to 5.
